# EUROPEAN PATENT APPLICATION

(11) **EP 2 952 550 A1**
(43) Date of publication of application: **09.12.2015**
(21) Application number: 14746160.2
(22) Date of filing: 29.01.2014
(51) Int. Cl.: C09K 3/14, C09G 1/02, H01L 21/304

(54) **SURFACE-SELECTIVE POLISHING COMPOSITION**

(30) Priority: 01.02.2013 US 201361759956 P
(71) Applicant: Fujimi Incorporated, Kiyosu-shi, Aichi 452-8502 (JP)
(72) Inventor: KIM, Hooi-Sung, Tualatin, Oregon 97062 (US); MILLER, Anne, Tualatin, Oregon 97062 (US)
(74) Representative: Grünecker Patent- und Rechtsanwälte PartG mbB
(86) International application number: PCT/JP2014/000461
(87) International publication number: WO 2014/119301

(57) **Abstract**

The present invention provides polishing compositions that show a high polishing rate ratio of a silicon nitride (SiN) surface to a silicon oxide surface, and/or of a SiN surface to a polycrystalline silicon (Poly Si) surface. Such compositions comprise, in certain aspects, of colloidal silica, and one or more water soluble polymers, and has a pH of 6 or less, wherein the colloidal silica comprises one or more organic acids bound to its surface, and the water soluble polymer is a polyoxyalkylene hydrocarbyl ether which hydrocarbyl group has 12 or more carbon atoms.

## Description

### Technical Field

The present invention is related to polishing compositions comprising silica and a water soluble polymer that show high polishing rate ratios of a silicon nitride (SiN) surface to a silicon oxide surface, and/or of a SiN surface to a polycrystalline silicon (Poly Si) surface.

### Background Art

A silicon nitride film removal step in semiconductor device manufacture can be conducted in various situations, for example, removal of a silicon nitride film as a stopper film in a step of element isolation structure formation, and the like. Conventionally, it is the common practice to conduct such a step by wet etching treatment with a mixture of phosphoric acid and nitric acid, or the like at high temperatures of about 150°C. A polishing step using abrasives has hardly been employed for removing a silicon nitride film.

For example, in the method described in Patent Document 1, a selectivity ratio represented by (polishing rate of a silicon nitride film) / (polishing rate of a silicon oxide film) increases about ten times by adding phosphoric acid or a phosphoric acid derivative to silicon oxide abrasives. In case of using the polishing composition described in Patent Document 1, in a step of polishing a silicon nitride film and then terminating polishing when a surface having both the silicon oxide film and the silicon nitride film is exposed, a harmful effect occurs that the silicon nitride film that should be left is chemically eroded at the time of excessive polishing, to some extent. In addition, since phosphoric acid itself penetrates through the silicon film or silicon oxide film, it may have an influence on the electrical properties of the semiconductor device to be manufactured. Decreasing an additive amount of phosphoric acid or phosphoric acid derivative in order to prevent or suppress such adverse effects also decreases a polishing rate of the silicon nitride film, which may not only deteriorate the removal efficiency of the silicon nitride film but also reduce the selectivity. As a result, the silicon oxide film which should originally serve as a stopper film is inevitably polished together and erosion causing relative recesses, depending on the exposure density of the stopper film, damages the flatness.

Patent Document 2 proposes control of the pH of a polishing slurry to fall within a range of from 1 to 5 in order to provide a polishing composition having a high selectivity ratio with respect to nitride (such as silicon nitride film). Even using this composition is detrimental similar to the composition described in Patent Document 1 and moreover, due to the polishing rate of the silicon oxide film attributable to mechanical polishing power of abrasives themselves, the target selectivity ratio decreases markedly to about 2.

Patent Document 3 proposes a polishing composition having a pH of from 2.5 to 5 and containing colloidal silica and a sulfonic acid group or an organic acid having a sulfonic acid group. This polishing composition, however, does not fully satisfy users' demand relating to a polishing rate of silicon nitride.

### Citation List

### Patent Literature

Patent Document 1: JP 11-176773 A
Patent Document 2: JP 2004-214667 A
Patent Document 3: JP 2010-41037 A

### Summary of Invention

### Technical Problem

In a semiconductor device manufacturing process, there is a need to grind, polish, and/or remove SiN at high speed, and to polish SiN selectively with respect to silicon oxide and/or Poly Si with high selectivity ratio. An object of the present invention is to provide polishing compositions and polishing methods related for to such polishing SiN with high selectivity ratio.

### Summary

The present invention can provide polishing compositions that show high polishing rate ratios of a SiN surface to a silicon oxide surface, and of a SiN surface to a Poly Si surface, which contain silica and a water soluble polymer, using the polishing compositions according to the following embodiments.

In one embodiment, such polishing compositions comprise silica and a water soluble polymer and have a pH of 6 or less, wherein the silica comprises one or more organic acids which is bound to a surface thereof, and the water soluble polymer is a polyoxyalkylene hydrocarbyl ether which hydrocarbyl group has 12 or more carbon atoms.

In one embodiment, the silica is colloidal silica. The silica is an effective abrasive agent that polishes and/or grinds the various surfaces, as provided herein.

In one embodiment, the polyoxyalkylene hydrocarbyl ether is C₁₈H₃₇O(CH₂CH₂O)₂₀H or polyoxyethylene(20)stearyl ether.

In another embodiment, the polyoxyalkylene hydrocarbyl ether is present in an amount that is 0.001% to 0.5% by mass of the composition. In another embodiment, the polyoxyalkylene hydrocarbyl ether is present in an amount that is 100ppm to 450ppm by mass of the composition. If the amount of the polyoxyalkylene hydrocarbyl ether in the composition is less than 0.001% or more than 0.5%, a polishing rate ratio of a polishing rate of a SiN surface to polishing rate of a silicon oxide surface and/or a Poly Si surface tends to decrease.

In another embodiment, the composition further comprises an organic acid other than that bound to the colloidal silica.

In various embodiments, the SiN/silicon oxide and/or the SiN/Poly Si removal selectivities of the compositions provided herein are controlled by dilution of the polishing composition, particularly, the silica component of the composition. In some embodiments, the SiN/silicon oxide removal selectivity increases with decreasing concentration of the silica.

Surprisingly, the SiN/Poly Si removal selectivity of the composition provided herein is controlled by modulating the concentration of the water soluble polymer. The higher the concentration of the water soluble polymer, the higher the SiN/Poly Si removal selectivity. Without being bound by theory, it is contemplated that the water soluble polymer resides on and/or covers the Poly Si to a greater extent compared to SiN and impedes the removal of Poly Si during polishing.

Also provided herein are methods for polishing comprising using the compositions provided herein. The compositions and methods provided herein are useful, for example, in semiconductor manufacturing process. In some embodiments, such compositions are useful in methods employing soft polishing pads. In other embodiments, such compositions are useful in methods employing hard or medium hard polishing pads. Non limiting examples of such harder pads include hard polyurethane pads.

In another embodiment, the method for polishing comprises contacting SiN, silicon oxide, and/or Poly Si, with a composition provided herein. In another embodiment, the SiN is selectively removed compared to silicon oxide and/or Poly Si.

### Brief Description of Drawings

FIG.1 graphically illustrates and tabulates the polishing superiority of a composition of the present invention over that of a low defect ILD composition.
FIG.2 graphically illustrates that Sample A of the present invention yields comparable or lower defect count than Sample B of prior art.
FIG.3 graphically illustrates the selective SiN polishing ability, over that of TEOS and Poly Si, of Sample A the present invention, and the effect of the concentration of the composition on polishing rate and selectivity.
FIG.4 graphically illustrates and tabulates the polishing efficiency of Sample A.
FIG.5A graphically illustrates the effect that changing the concentration of the composition of the present invention on polishing rate and polishing selectivity.
FIG.5B graphically illustrates the effect that changing the concentration of the composition of the present invention on polishing rate and polishing selectivity.

### Description of Embodiments

The following terms used herein are defined as follows: "a" or "an" include plural forms as the context indicates. For example, a pH adjustor means one or more pH adjustors.

"About" refers to ±1%, ±5%, or ±10% or a quantity, as the context indicates. As used herein, every amount, number, and ranges of each thereof are preceded by the term "about."

"Hydrocarbyl" refers to a moiety containing carbon and hydrogen atoms. The number of carbon atoms is usually about 1-70 (C₁-C₇₀).

"Alkyl" refers to a saturated, linear or branched, monovalent hydrocarbyl moiety. The number of carbon atoms is usually 1-40.

"Alkenyl" refers to a linear or branched, monovalent hydrocarbyl moiety, containing up to 5 carbon-carbon double bonds. The number of carbon atoms is usually 1-40.

"Alkynyl" refers to a linear or branched, monovalent hydrocarbyl moiety, containing up to 5 carbon-carbon triple bonds. The number of carbon atoms is usually 1-40.

"Aryl" refers to an aromatic, cyclic hydrocarbyl moiety. The number of carbon atoms is usually 6-10.

"Cycloalkyl" refers to a cyclic, non-aromatic hydrocarbyl moiety. Cycloalkyl can be completely saturated or partially unsaturated. The number of carbon atoms is usually 3-15. A partially unsaturated cycloalkyl group contains 1-4 carbon carbon double bonds.

"Alkylene" refers to a saturated, divalent, linear or branched hydrocarbyl moiety. The number of carbon atoms is usually 2-200.

"Polyoxyalkylene" refer to an alkylene, where 8-60 oxygen atoms replace the chain carbon atoms. The number of repeating of oxyalkylene is usually 8-60.

### (Compositions and Methods)

The present invention provides polishing compositions that show high polishing rate ratios of a SiN surface to a silicon oxide surface, and of a SiN surface to a Poly Si surface. Such compositions comprise, in one aspect, of silica, and a water soluble polymer and has a pH of 6 or less, wherein the silica comprises one or more organic acids or salts thereof, which is bound to a surface thereof, and the water soluble polymer is a polyoxyalkylene hydrocarbyl ether which hydrocarbyl group has 12 or more carbon atoms. If the number of carbon atoms is less than 12, a polishing rate ratio of a polishing rate of a SiN surface to polishing rate of a silicon oxide surface and/or a Poly Si surface tends to decrease.

### A. Silica

In one embodiment, the silica is colloidal silica. In one embodiment, the silica comprises silica derivatized with 1-6, 2-5, or 3-4 kinds of organic acid groups or salts thereof bound to each particle. In some embodiments, the organic acid is one or both of a carboxylic acid and a sulfonic acid. Methods of covalently attaching such organic acids to the silica such that a functional group of the organic acids is bound to the silica will be understood by the skilled artisan. For example, in case of covalently attaching a sulfonic acid which is one kind of the organic acids to the colloidal silica, we can see Cano-Serrano et al., "Sulfonic acid-functionalized silica through quantitative oxidation of thiol groups", Chem. Commun., 2003, 246-247. Specifically, the colloidal silica in which sulfonic acids are covalently attached to its surface is obtained by coupling silane coupling agents having a thiol group such as (3-Mercaptopropyl) trimethoxysilane with the colloidal silica and then oxidizing the thiol group using a hydrogen peroxide water. Alternatively, for example, in case of covalently attaching a carboxylic acid to the colloidal silica, we can see "Novel silane coupling agents containing a photolabile 2-nitrobenzyl ester for introduction of a carboxy group", Yamaguchi et al., Chemistry Letters, 3, 228-229 (2000). Specifically, the colloidal silica in which a carboxylic acid is covalently attached to its surface is obtained by coupling silane coupling agents containing photosensitive 2-nitrovinzyl ester with the colloidal silica and then irradiating it by light.

In another embodiment, the average primary particle diameter of colloidal silica is 5 nm or more, 7 nm or more, or 10 mm or more. In certain embodiments, the polishing speed of the SiN by the compositions provided herein increases as the average primary particle diameter of colloidal silica increases.

In other embodiments, the average primary particle diameter of colloidal silica is 150 nm or less, 120 nm or less, or 100 nm or less. The average primary particle diameter of colloidal silica is calculated based on the specific surface area of the colloidal silica, for example, based on a BET adsorption method.

In another embodiment, the colloidal silica is of a non-globular or non-spherical form. As for colloidal silica of a non-spherical shape, two or more primary particles may join. As for the average degree of association of the colloidal silica, in certain embodiments, it is 1. 2 or more or 1. 5 or more. In other embodiments, the average degree of association of colloidal silica is 4.0 or less, 3.0 or less or 2.5 or less.

As for the content of the colloidal silica, in certain embodiments, it is at least 0.05 mass %, at least 0.1 mass %, or at least 0.3 mass % with respect to the total mass of the composition. In other embodiments, the content of the colloidal silica is below 5 mass %, below 1 mass %, or is below 0.9 mass % with respect to the total mass of the composition. In other embodiments, the colloidal silica is present in an amount of 0.5 mass %, 0.2-0.8 mass %, or 0.1-0.9 mass % with respect to the total mass of the composition.

### B. Water Soluble Polymer

In some embodiments, the compositions provided herein comprise a water soluble polymer. In some embodiments, the compositions provided herein essentially contain a water soluble polymer. In some embodiment, the water soluble polymer may be referred to as a surfactant. In one embodiment, the water soluble polymer is of Formula I: 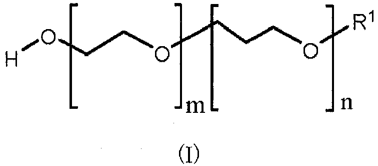 or a sulfate, an organic carboxylate, or a phosphate ester thereof.

Further, in another embodiment, the water soluble polymer is of Formula II: 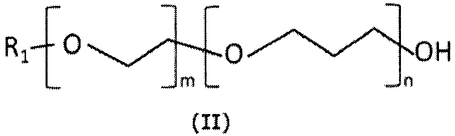 or a sulfate, an organic carboxylate, or a phosphate ester thereof.

Further, in another embodiment, the water soluble polymer is of Formula III: 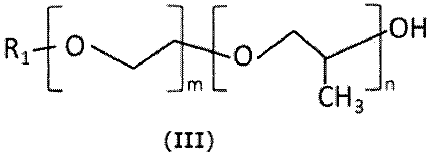 or a sulfate, an organic carboxylate, or a phosphate ester thereof.

In the above Formulas I to III, m is 10-30, n is 0-30, and R¹ and R₁ are hydrocarbyl moieties. The structure of Formulas (I) and (II) is meant to include copolymers and block polymers of ethylene and propylene glycols. In the above Formulas I to III, when m is less than 10 and/or, m and/or n are more than 30, a polishing rate ratio of a polishing rate of a SiN surface to a polishing rate of a silicon oxide surface and/or a Poly Si surfaces tends to decrease.

In one embodiment, R¹ is C₁₀-C₃₀ alkyl, C₁₀-C₃₀ alkenyl, or C₁₀-C₃₀ alkynyl, wherein each alkyl, alkenyl, or alkynyl group is optionally substituted with 1-3 C₆-C₁₀ aryl or C₃-C₁₀ cycloalkyl group. In another embodiment, R¹ is C₆-C₁₀ aryl or C₃-C₁₀ cycloalkyl optionally substituted with 1-3 C₁-C₆ alkyl group. In another embodiment, R¹ is C₁₅-C₂₅ alkyl or C₁₇-C₂₃ alkyl.

In one embodiment, n is at least 1. In another embodiment, n is 0. In another embodiment, m is 15-25 or 18-22. In another embodiment, m+n is 15-25. In another embodiment, the water soluble polymer is C₁₈H₃₇-CH₂-O-(CH₂CH₂O)₂₀H or C₁₈H₃₇-O- (CH₂CH₂O)₂₀H.

In some embodiments, the water soluble polymer has a hydrophobic lipophilic balance (HLB) value that is at least 10, at least 12, or at least 14. In other embodiments, the water soluble polymer has an HLB value that is 20 or less. In yet other embodiments, the HLB value is 11-20, 12-19, 13-18, or about 14-17. When the HLB value is less than 20, the water soluble polymer is difficult to dissolve in water and a polishing rate ratio of a polishing rate of a SiN surface to a polishing rate of a silicon oxide surface and/or a Poly Si surface tends to decrease.

In some embodiments, the water soluble polymer is present in the composition in an amount of 0.001 g/L or more, 0.005 g/L or more, or 0.01 g/L or more. In other embodiments, the water soluble polymer is present in an amount of 10 g/L or less, 5 g/L or less, or 1 g/L or less. In other embodiments, the water soluble polymer is present in an amount that is 0.001% to 0.5% by mass of the composition. In other embodiments, the water soluble polymer is present in an amount that is 200 ppm (or 0.02%) or less, 100-450 ppm, or 50-450 ppm with respect to the composition. In particular, when the water soluble polymer is present in an amount of 100-450 ppm, it is more preferable because SiN removal selectivity is good. A composition provided herein comprising 200 ppm of a water soluble polymer, of Formula (I), demonstrated surprising SiN removal selectivity over Poly Si and silicon oxide, as illustrated and tabulated in the FIGs herein.

### C. pH of the Composition

In one embodiment, the pH of the composition is 6 or less. In other embodiments, the pH is 5 or less, 4 or less, or 4.5 or less. In other embodiments, the pH is 1 or more, 1.5 or more, or 2.5 or more. In one embodiment, the pH is 3. In some embodiments, when the pH exceeds 6, it may be difficult to polish SiN at high speed using the composition.

A pH adjuster may be used for adjusting the pH of the composition to a desired value. The pH adjuster used may be an inorganic acid or and organic acid, or may be a chelating agent.

For example, and without limitation, such inorganic acids include, hydrogen chloride, sulfuric acid, nitric acid, fluoric acid, boric acid, carbonic acid, hypophosphorous acid, phosphorous acid, and phosphoric acid.

For example, and without limitation, such organic acids include, formic acid, acetic acid, propionic acid, butanoic acid, a valeric acid, 2-methylbutyric acid, N-hexanoic acid, 3,3-dimethylbutanoic acid, 2-ethylbutanoic acid, 4-methylpentanoic acid, n-heptanoic acid, 2-methyl hexanoic acid, n-octanoic acid, 2-ethylhexanoic acid, benzoic acid, glycolic acid, salicylic acid, glyceric acid, oxalic acid, malonic acid, succinic acid, glutaric acid, adipic acid, pimelic acid, maleic acid, phthalic acid, malic acid, tartaric acid, citrate, lactic acid, diglycolic acid, 2-furancarboxylic acid, 3-furancarboxylic acid, 2-tetrahydro furancarboxylic acid, methoxy acetic acid, methoxyphenyl acetic acid, and phenoxyacetic acid. Such organic acids also include, without limitation, organic sulfonic acid, such as methanesulfonic acid, ethane sulfonic acid, and isethionic acid.

In other embodiments, salts, such as ammonium salts of inorganic acids or organic acids and alkaline metal salts, may be used as a pH adj uster in combination with one or more inorganic acids or organic acids.

Examples of chelating agents include, without limitation, hydroxy ethylimino-2-acetic acid, an iminodiacetic acid, an acetamide iminodiacetic acid, nitrilo-3-propanoic acid, nitrilo-3-methylphosphonic acid, nitrilotriacetic acid, a diethylenetriamine pentaacetic acid, and ethylenediaminetetraacetic acid.

In one embodiment, lactic acid or another organic acid is present in an amount that is 0.001-1%, 0.01-0.1%, or 0.09% by mass with respect to the composition.

### D. Polishing speed

In some embodiments, while the composition for polishing can polish SiN at high speed, it may not be desirable to polish Poly Si at high speed. In some embodiments, where the surface of the object being polished contains not only SiN but also Poly Si, the ratio of the polishing speed of the SiN to the polishing speed of Poly Si is preferably 2 or more, more preferably 4 or more, further preferably 6 or more.

In some embodiments, where the surface of the object being polished contains not only SiN but also silicon oxide and/or Poly Si, the ratio of the polishing speed of the SiN to the polishing speed of silicon oxide and/or Poly Si is preferably 2 or more, more preferably 4 or more, further preferably 6 or more. Thus in some embodiments, when separately polishing a silicon oxide surface and a SiN surface, or a Poly Si surface and a SiN surface under similar polishing conditions using the compositions provided herein, the polishing rate ratio of the SiN surface to the polishing speed of silicon oxide and/or Poly Si surfaces are comparable or higher, as described herein.

Without being bound by theory, at a pH of 6 or less, the F-potential of the colloidal silica, in which organic acids are bound to its surface, which comprises organic acid(s) is a negative potential. The zeta-potential of SiN is a positive potential at pH 6 or less. Therefore, if the pH of the composition provided herein is 6 or less, colloidal silica in a composition for polishing will be electrostatically attracted by SiN. Therefore, according to this composition for polishing, SiN can be polished at high speed, as a result SiN can be polished preferentially over silicon oxide or Poly Si.

### E. Other Additives

In some embodiments, the compositions provided herein further comprise oxidizers, such as hydrogen peroxide, or an antiseptic or an antifungal agent. Nonlimiting examples of antiseptic and antifungal agents include, isothiazoline system antiseptics, such as 2-methyl-4-isothiazoline-3-one and 5-chloro-2-methyl-4-isothiazoline 3-one, p-hydroxybenzoate esters, and phenoxyethanol.

In some embodiments, polishing compositions used for polishing are prepared by diluting a composition, also provided herein, 4 to 10 folds or more, diluting a concentrated solution of polishing compositions, using a dilution liquid such as an aqueous solution or water.

Other polishing compositions and methods of making and using them are described in WO 2012/026329 (incorporated herein by reference), which can be appropriately modified and adapted in view of this disclosure to provide other compositions of this disclosure, and other methods of making and using such compositions and those described herein.

### (General Procedure for preparing the compositions and measuring polishing speed)

In general, colloidal silica and the water soluble polymer (for example, Polyoxyethylene (20) stearyl) is mixed in water and the pH of the composition is adjusted suitably with a pH adjustor (for example, lactic acid) . The temperature when mixing each component is not limited, but 10 to 40° C is preferable. It can be heated in order to increase a solubility speed. Further, mixture time is also not limited.

As for a polishing device, a general polishing device having a turn table to which a polishing pad (abrasive cloth) can be pasted can be used such as a device provided with a holder holding a substrate etc. having a target of polishing, a motor which can change the number of rotations, and the like.

The polishing condition is also not limited. For example, a rotation speed of the turn table is preferably 10 to 500rpm, a pressure against a substrate having a target of polishing (pressure of polishing) is preferably 0.5 to 10psi. A method of feeding polishing compositions to the polishing pad is also not limited, and for example, a method of feeding continuously by a pump etc. can be adopted. This feeding quantity is not limited, but a surface of the polishing pad is preferably always covered with a polishing composition of the present invention.

After polishing, the substrate is washed with flowing water and by shaking off drops of water attached on the substrate by a drier etc., and then a substrate can be obtained.

Polishing speed of a SiN or another surface as described herein is measured based on polishing a wafer for a period of time. The polishing speed is calculated by measuring the difference of the thickness of the wafer before and after the polish, and the polishing time. The thickness difference is measured using, for example, the light interference type thickness measurement device.

### [Example 1]

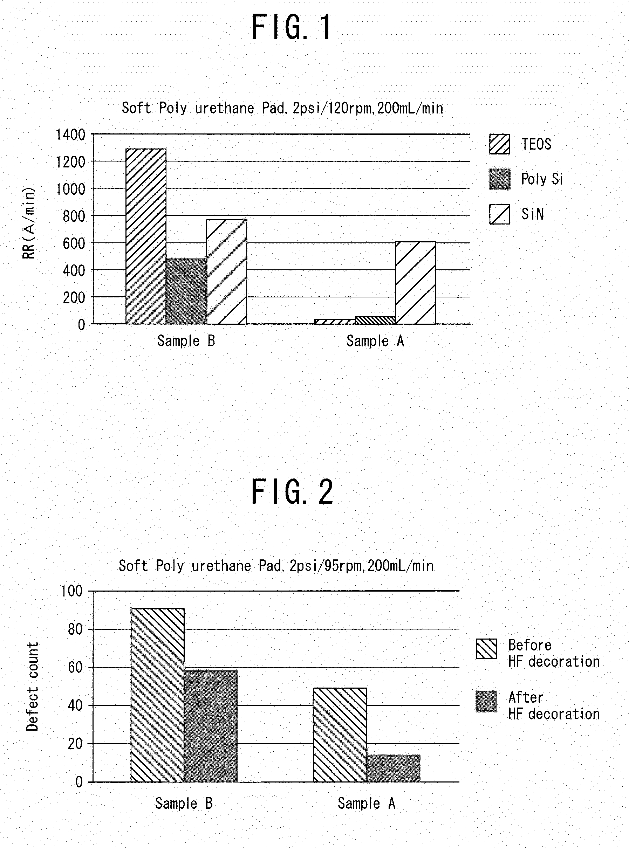

A polishing composition containing 0.5% of colloidal silica in which sulfonic acids are covalently attached to its surface(average primary particle size: about 35 nm, average secondary particle size: about 70 nm), 0.09% of lactic acid, and 200 ppm of polyoxyethylene (20) stearyl ether and having a slurry pH adjusted to 3 was prepared as Sample A. Separately, a composition similar to Sample A except that it did not contain polyoxyethylene (20) stearyl ether was prepared as Sample B. The surface of each of tetraethyl silicate (TEOS) as a silicon oxide, polysilicon, SiN wafers having a diameter of 200mm was polished with each of Sample A and Sample B as a polishing composition at a slurry flow rate of the polishing composition of 300 mL/min, a pressure of polishing of 2 psi, and a platen rotation speed of 120 rpm, while using a soft polyurethane pad (Shore hardness A63). The polishing speed of each of the wafers is shown in Table 1 and FIG. 1. The term "slurry flow rate of the polishing composition" means a total supply amount of all the supplied liquids per unit time (which will equally apply to examples described below).

It has been found that when Sample A, that is, the polishing composition of the invention is used, the polishing rate of each of the wafers is high, particularly, a polishing rate ratio of SiN to TEOS is high (>10:1).

### [Example 2]

A TEOS wafer having a diameter of 300 mm was polished with each of Sample A and Sample B obtained in Example 1 before and after HF decoration at a slurry flow rate of the polishing composition of 200 mL/min, a pressure of polishing of 2 psi, and a platen rotation speed of 95 rpm while using a soft polyurethane pad (Shore hardness A63). The surface defect count after polishing the TEOS wafer was measured using a light interference type surface analyzer before and after HF decoration. The results are shown as graph in FIG. 2.

Using Sample A, that is, the polishing composition of the invention can markedly decrease the surface defect count.

### [Example 3]

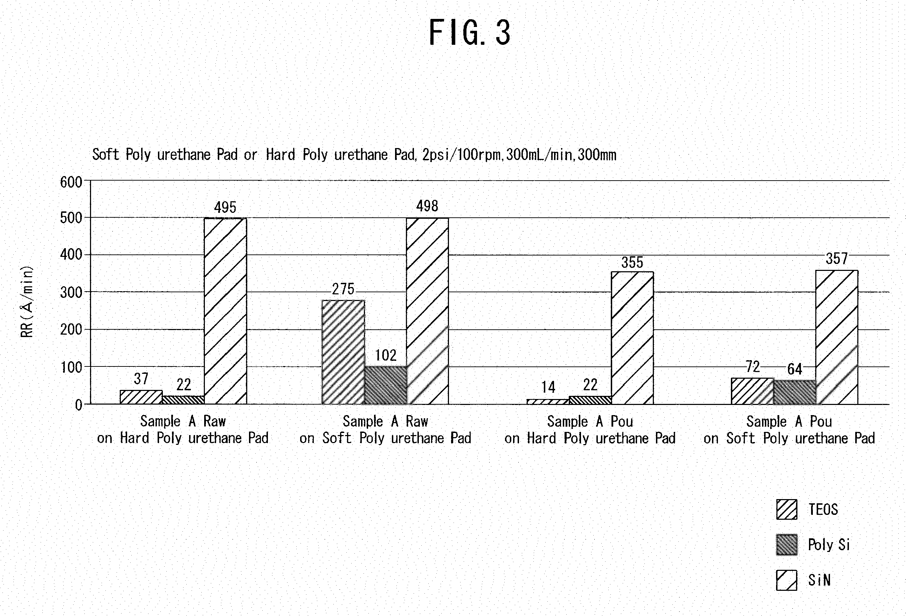

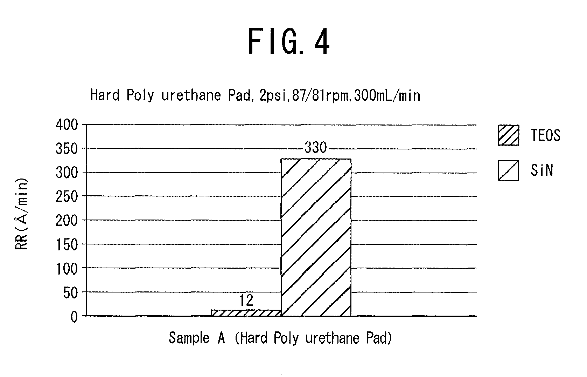

FIG. 3 shows a graph of a polishing speed when each of TEOS, polysilicon wafer, and SiN wafer having a diameter of 300 mm was polished using Sample A and Sample A (concentrated), that is, a polishing composition obtained by concentrating Sample A of Example 1 to 4 times, at a slurry flow rate of the polishing composition of 300 mL/min, a pressure of polishing of 2psi, and a platen rotation speed of 100 rpm, while using a hard polyurethane pad (Shore hardness D60) and a soft polyurethane pad (Shore hardness A63). The polishing speed is shown as graph in FIG. 4.

It has been found that a high polishing rate ratio of SiN relative to TEOS and polysilicon can be achieved using Sample A, that is, the polishing composition of the invention and the concentrated composition thereof, but with a decrease in the concentration of the polishing composition, the polishing speed decreases.

**Table 1**

| | TEOS | Poly Si | SiN | SiN/TEOS | Poly Si/TEOS | SiN/Poly Si |
|---|---|---|---|---|---|---|
| Sample B | 1291 | 485 | 772 | 0.6 | 0.4 | 1.6 |
| Sample A | 34 | 55 | 609 | 17.8 | 1.6 | 11.1 |

| | | | | | | |
|---|---|---|---|---|---|---|
| Unit (A/min) | | | | | | |

### [Example 4]

Polishing speeds when TEOS and SiN wafers having a diameter of 300 mm were each polished with Sample A obtained in Example 1 at a slurry flow rate of the polishing composition of 300 mL/min, a pressure of polishing of 2 psi, a platen rotation speed of 87 and a head rotation speed of 81 rpm, while using a hard polyurethane pad (Shore hardness D60) are shown in FIG. 4 and Table 2.

It has been found that using the polishing compositions of the invention, Sample A and the concentrated composition thereof can achieve a high polishing rate ratio of SiN with respect to TEOS.

**Table 2**

| Slurry ID | TEOS | SiN | SiN/TEOS |
|---|---|---|---|
| Sample A (Hard Poly urethane Pad) | 12 | 330 | 27.3 |

| | | | |
|---|---|---|---|
| Unit (Å/min) | | | |

### [Example 5]

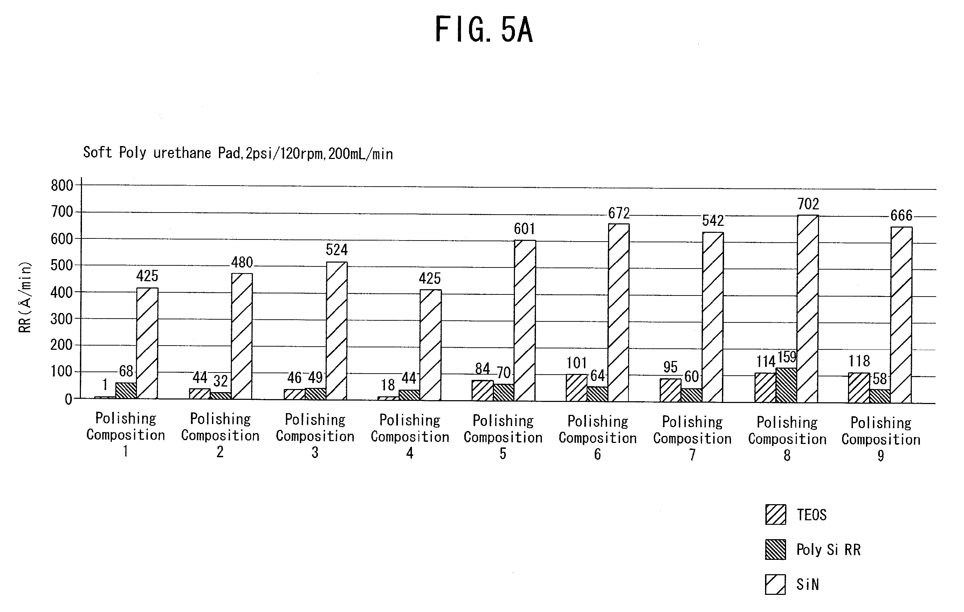

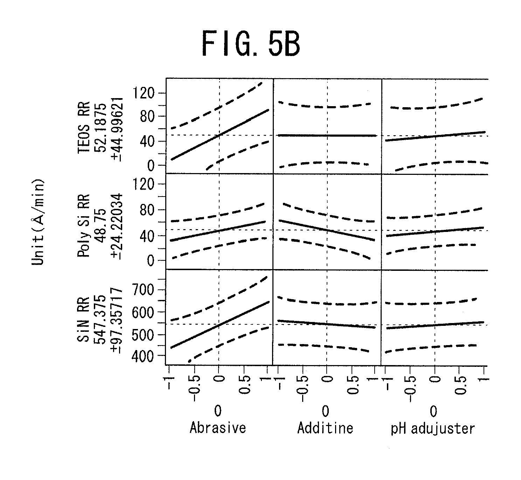

Polishing rates when TEOS, polysilicon, and SiN having a diameter of 200 mm were each polished with Polishing compositions 1 to 9 having the composition shown in Table 3 at a slurry flow rate of the polishing composition of 200 mL/min, a pressure of polishing of 2 psi, and a platen rotation speed of 120 rpm while using a soft polyurethane pad (Shore hardness A63) are shown as a graph in FIGS. 5A and 5B.

It has been found that an increase in the concentration of an abrasive (silica) in the polishing composition increases a TEOS removal efficiency, but decreases SiN:TEOS silica removal selectivity.

**Table 3**

| | Polishing Composition 1 | Polishing Composition 2 | Polishing Composition 3 | Polishing Composition 4 | Polishing Composition 5 | Polishing Composition 6 | Polishing Composition 7 | Polishing Composition 8 | Polishing Composition 9 |
|---|---|---|---|---|---|---|---|---|---|
| Abrasive | 0.25wt% (-) | 0.25wt% (-) | 0.25wt% (-) | 0.25wt% (-) | 0.5wt% (0) | 0.75wt% (+) | 0.75wt% (+) | 0.75wt% (+) | 0.75wt% (+) |
| pH Adujuster (Lactic Acid) | 0.05wt% (-) | 0.05wt% (-) | 0.13wt% (+) | 0.13wt% (+) | 0.09wt% (0) | 0.05wt% (-) | 0.05wt% (-) | 0.13wt% (+) | 0.13wt% (+) |
| Water Soluble Polymer (Poly oxyethylene (20)Stearyl Ether) | 100ppm (-) | 300ppm (+) | 100ppm (-) | 300ppm (+) | 200ppm (0) | 100ppm (-) | 300ppm (+) | 100ppm (-) | 300ppm (+) |

### [Example 6]

Table 4 shows comparison in physical properties between Sample A and Sample A (concentrated) obtained by concentrating Sample A to 4 times and these properties at 55°C, thereby showing storage stability. This table suggests that Sample A (concentrated), the polishing composition of the invention, has slightly deteriorated storage stability by dilution. In addition, the composition and physical properties of the polishing composition of the invention are shown in Table 5 and a trace metal content is shown in Table 6.

**Table 4**

| | pH | SG | Viscocity (mPa.s) |
|---|---|---|---|
| RT Sample A | 2.94 | 1.00 | 1.09 |
| 55°C Sample A | 2.98 | 1.00 | 1.02 |
| RT Sample A (Raw) | 2.58 | 1.01 | 1.10 |
| 55°C Sample A (Raw) | 2.66 | 1.01 | 1.08 |

**Table 5**

| | Abrasive wt% | Specific gravity (SG) | pH | Viscocity (cps) | Electric Conductivity (EC) |
|---|---|---|---|---|---|
| Sample A | 2 | 1.005-1.015 | 2.5-2.7 | 1.0-1.15 | 0.9-1.1 |

**Table 6**

| | Ca | Cr | Fe | Mg | Na | Ni |
|---|---|---|---|---|---|---|
| Sample A (ppb) | 14 | 0 | 0 | 51 | 192 | 139 |

## Claims

1. A polishing composition comprising colloidal silica and a water soluble polymer, the polishing composition having a pH of 6 or less, wherein
the colloidal silica comprises organic acids bound to the colloidal silica,
the water soluble polymer comprises a polyoxyalkylene hydrocarbyl ether, and
the hydrocarbyl group of the polyoxyalkylene hydrocarbyl ether has 12 or more carbon atoms.

2. The composition of claim 1, wherein
the polyoxyalkylene hydrocarbyl ether is of formula: 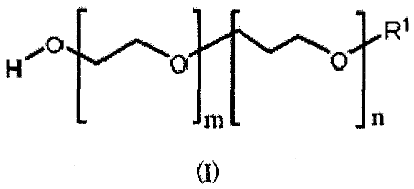 or a sulfate, an organic carboxylate, or a phosphate ester thereof, wherein
m is 10-30, n is 0-30, and R¹ is the hydrocarbyl moiety.

3. The composition of claim 1, wherein
the polyoxyalkylene hydrocarbyl ether has a hydrophobic lipophilic balance (HLB) value that is 11-20.

4. The composition of claim 1, wherein
the polyoxyalkylene hydrocarbyl ether is polyoxyethylene(20)stearyl ether.

5. The composition of any one of claims 1-4, wherein
the polyoxyalkylene hydrocarbyl ether is present in an amount that is 100 to 450 ppm by mass of the composition.

6. A method of polishing comprising contacting SiN, silicon oxide, and/or Poly Si, with a composition of any one of claims 1-5.

7. The method of claim 6, wherein
the SiN is selectively removed compared to silicon oxide and/or Poly Si.
